# EUROPEAN PATENT SPECIFICATION

(11) **EP 1 944 887 B1**
(45) Date of publication and mention of the grant of the patent: **06.11.2013**
(21) Application number: 07000546.7
(22) Date of filing: 11.01.2007
(51) Int. Cl.: H03J 1/00, H04L 25/00, H04L 27/00

(54) **Radio receiver for hybrid broadcast systems**
Radioempfänger für hybride Sendersysteme
Récepteur pour les systèmes d'émission hybrides

(43) Date of publication of application: 16.07.2008
(73) Proprietor: Harman Becker Automotive Systems GmbH, 76307 Karlsbad (DE)
(72) Inventor: Becker, Karl-Anton, 76307 Karlsbad (DE); Obergfell, Philip, 76307 Karlsbad (DE); Ton That Giang, Binh, 76307 Karlsbad (DE)
(74) Representative: Bertsch, Florian Oliver

(56) References cited:
- EP-A2- 0 669 763
- EP-A2- 1 434 371
- US-A- 5 809 065
- US-B1- 6 600 908
- US-B1- 7 088 740

## Description

This invention relates to a method for controlling a radio receiver receiving a hybrid signal containing digitally and analogously broadcast signal components and to a radio receiver receiving such a hybrid signal. These hybrid signals are transmitted from a hybrid broadcast system which generally uses analog and digital modulation techniques at the same time so that a suitable receiver has to be able to demodulate and decode both signals giving the user the possibility to either manually choose which program and associated data should be output via the receiver's loudspeakers and graphical interface or automatically choosing the signal with the better reception quality as source for the output.

### Related art

Many modern radio receivers for mobile reception consist of two reception paths. One is utilized to receive, demodulate and decode the program the user chooses while the second path is utilized to gather information from other stations (e.g. to generate a station list or to provide traffic information).

The latter method is often referred to as background reception. In detail many modern receivers include two tuners that can be individually tuned to different frequencies connected to a signal processor that is capable of demodulating and decoding both received signals individually. Many modern radio receivers make use of a digital signal processor that is connected to the outputs of one analog-to-digital-converter for each output signal to the two tuners. The latter receiver architecture is often referred to as Digital IF Receiver.

In order to upgrade such a digital IF receiver to be capable of additionally receiving, demodulating and decoding the digital broadcast signal of a hybrid broadcast system modification of one of the tuner might be necessary (e.g. additional filtering) and an additional signal processing path has to be provided that is fed by the output signal of the A/D-converter connected to the tuner modified for reception of the digital broadcast signal. Additionally there has to be a stage where the audio output of either the analog or the digital reception path can be chosen as output signal of the receiver (blending). In a receiver modified in the way described above one tuner with its corresponding signal processing path is dedicated to reception of the analog broadcast signal and the other tuner with its corresponding signal processing path is dedicated to reception of the digital broadcast signal of a hybrid broadcast system.

Since this receiver for a hybrid broadcast system includes the same hardware that is used by a normal dual receiver capable of background reception as described above, a need exists to use the existing receiver hardware for both purposes - reception of a hybrid broadcast signal and background reception - at the same time. This would eliminate the need for additional hardware (additional tuner and A/D-converter).

Radio receivers are often used in vehicles in combination with a navigation system guiding the user from a predetermined location to a certain destination. In order to calculate the fastest route to the destination, navigation systems often use information comprised in the received radio program in which data for traffic information is contained that can be decoded by the receiver. The traffic information helps to calculate the fastest route to the desired destination avoiding closed or congested routes.

### Summary of the invention

In case of a radio receiver capable of receiving and decoding a hybrid signal, a need exists to allow the reception and the output the received radio program with the best quality while allowing the second tuner to provide background reception as often as possible in order to collect data like traffic information or to create a station list of the possible radio stations. Furthermore, the receiver should be changed as little as possible.

This need is met by the features of the independent claims. In the dependent claims preferred embodiments of the invention are described.

According to a first aspect of the invention, a method is provided for controlling a radio receiver comprising two tuners, the method comprising the step of receiving the hybrid signal and controlling the two tuners in such a way that a selection of the operating modes of the receiver is made between the following operating modes: in a first operating mode both tuners are tuned to the same broadcast hybrid signal, one of the tuners being configured for receiving the digitally broadcast signal, the other tuner receiving the analogously broadcast signal. As an alternative the radio receiver could operate in a second operating mode in which one of the tuners receiving the digitally broadcast signal is the operating tuner, whereas the other tuner is working as search and check tuner. In the second operating mode the receiver receives a digitally broadcast signal and uses this signal for the audio output so that the second receiver can work as search and check receiver scanning the frequency band in order to collect traffic information data or in order to collect information which station can be received on the different frequencies. Furthermore, the radio receiver can work in a third operating mode in which one of the tuners receiving the analogously broadcast signal is the operating tuner whereas the other tuner is working as a search and check tuner. In this embodiment no digitally broadcast signal can be received or at least no digitally broadcast signal in an acceptable signal quality can be received which could be used for the audio output. Accordingly, one of the tuners uses the normal analog signal for the audio output, the other tuner being free for the collection of additional data. Preferably, the radio receiver is controlled in such a way that a selection of the operating modes is done between the three modes mentioned above so that the radio receiver works in either of the three modes. In the first mode one of the tuners, e.g. the first tuner, is adapted for receiving the digitally broadcast signal component, the second tuner receiving the normal analogously broadcast signal component. This operating mode is used for checking whether a digital signal component is available. After this check the radio receiver works either in the second or third operating mode, in which the other tuner which is not the operating tuner used for the audio output can be used for searching the frequency range. The above-described invention provides the possibility to receive a hybrid broadcast signal having analog and digital components with a minimum amount of hardware. By way of example, a third tuner front end and additional A/D-converter for the third tuner is not necessary.

Preferably, the first operating mode is selected when the receiver was tuned to a new frequency in order to check whether the digitally broadcast signal component is available. In some digital radio applications, such as HD radio, the digital component is transmitted and broadcast together with the analog component on the same frequency. When the receiver is tuned to a new frequency it can be checked whether the digitally broadcast signal component can be received. This can be done in the first operating mode.

Furthermore, when it is detected that a digitally broadcast signal component is available, the second operating mode can be selected in which the digitally received signal component is then demodulated and decoded and used as audio output. If however, in the first operating mode it is detected that on a new frequency, no digital signal component can be received, the third operating mode can be selected in which both tuners work on the analog signal part.

When the radio receiver is working in the third operating mode in which the audio output is based on the analog signal component it can nevertheless be asked whether digitally broadcast signals can be received. If this is the case, the operating mode of the radio receiver is changed from the third to the second operating mode. Especially when the radio receiver is used in a vehicle, the receiving conditions will vary depending on the geographical region in which the vehicle is driving. For some geographical areas a digitally broadcast signal component may exist, whereas for other areas, this digital signal component may not exist. In order to take into account that the vehicle may have moved from a first region in which a reception of a digital signal component is not possible to another region where digital signal components are available the checking can be carried out from time to time.

Additionally, it is possible to introduce a predetermined timeout B after which the receiver changes to the first operating mode checking if a digital broadcast signal and the corresponding audio output has become available.

When working in the first operating mode it is possible to demodulate and decode the digitally broadcast signal and to demodulate and decode the analogously broadcast signal. In the first operating mode it might be helpful to use both tuners for the same signal since the digitally broadcast signal takes longer to be demodulated and decoded so at first the audio signal of the analog reception paths may be output. As soon as the digital signal is acquired and an audio output from the digital reception paths becomes available, the audio output of the receiver will be switched or blended to the digital audio signal. As a consequence, the operating mode is then changed to mode two.

According to another embodiment of the invention it is possible that, when the receiver is working in the third operating mode, the receiver changes to the first operating mode after a predetermined timeout C greater than timeout B mentioned above. In this embodiment the receiver is kept in the third operating mode for a longer time, prolonging the time for data collection by the search and check tuner. The time the receiver can support background reception is increased. Furthermore it is possible to increase the timeout C with a number of unsuccessful attempts to detect digitally broadcast signal components. Every time the receiver was not able to decode the audio output of the digitally broadcast signal while being configured in operating mode one, the timeout C can be increased. The more often the receiver changes to operating mode one and no digital component was detected, the longer the receiver will stay in operating mode three. And as soon as the receiver has demodulated and decoded a digitally broadcast signal component once, the timeout can be reset to its initial value. In geographical regions where no digital signal component exists, the increase of the timeout C can help to avoid that the receiver changes the operating mode too often. Every time the operating mode changes from mode three to mode one, the background reception is interrupted. This embodiment helps to decrease the unnecessary changing to operating mode one, when no digital signal component was received for a longer period of time.

Furthermore, it is possible, when a digitally broadcast signal can be received, to detect whether the detected digital signal can be detected for a predetermined period of time X. If the broadcast signal can be detected longer than the time X, the operating mode of the receiver is changed to the second operating mode. If a digital signal component can be detected only for short period of times smaller than X, the operating mode of the receiver can be the third operating mode. There exist reception situations where the reception quality of the digital broadcast signal does not allow continuous demodulation and decoding of the corresponding audio signal leading to frequent blending between the audio output of the digital and the analog reception path. In this context it may be desirable to force the receiver to stay in the third operating mode in which the audio output of the analogue reception path is used for longer periods of time. This has the advantage that for the user it will lead to a smoother sound impression and it will improve the performance of the background reception. Also it is possible that once the receiver has output the digital broadcast signal longer than time X the timeout C is reset to its initial value. Furthermore, the period of time X can be reset to its initial value when the receiver has output the audio signal of the digital signal component longer than the predetermined period of time X. Additionally, it is possible to increase the timeout C with the number of unsuccessful attempts to detect a digitally broadcast signal longer than the predetermined period of time X until a maximum value of timeout C = Tₘₐₓ is reached.

According to another embodiment it is additionally possible to check the quality of the received signal when the receiver is working in the third operating mode. If the quality is below a predetermined threshold value, the receiver can stay in the third operating mode. The reception quality can be checked e.g. by determining the field strength of the desired radio station. When the signal strength is below the threshold value it can be deduced that a demodulation and decoding of the digital signal cannot be made in a way needed for an audio output. In this situation it might be advisable to stay in the third operating mode.

When the receiver works in the second operating mode using the digital signal component for audio output, and when a loss of the digitally broadcast signal is detected, the receiver may switch to the other tuner which was working as search and check receiver and may tune this tuner to the frequency for which the loss of the digital component has occurred. When the digital signal component does not become available again, the operation of the receiver can be changed to the third operating mode after a predetermined amount of time. Additionally it is possible, when the receiver is working in the third operating mode to feed the signal from the tuner working as search and check tuner to the signal processing path for the demodulation and decoding of a digitally broadcast signal. This has the advantage that the receiver can collect further information from other stations broadcasting a hybrid or digitally broadcast signal. This operating mode can also be called digital background reception operating mode. It should be understood that it is also possible that the receiver is complemented by additional signal processing path or signal processing unit to allow background reception of digital broadcast signals as well.

The invention furthermore relates to a radio receiver configured for receiving a hybrid signal containing digital and analogue signal components the receiver comprising a first tuner adapted to receive the digitally and the analogously broadcast signal. Furthermore, a second tuner is provided adapted to receive the analogously broadcast signal. Furthermore, an antenna can be provided receiving the hybrid signal. In a signal processing unit the hybrid signal, i.e. the two components are demodulated and decoded. Furthermore, an operating mode selection unit is provided controlling the two tuners in such a way that a selection of the operating modes of the receiver is made between the above-described three operating modes. The radio receiver of the invention includes the same hardware used by a normal dual receiver capable of background reception. This receiver can now be used for receiving the hybrid signal, the receiver furthermore taking into account the fact that as many additional information as possible is gathered.

The receiver may further comprise a first analog-to-digital-converter receiving the signal from the first tuner and a second analog-to-digital-converter receiving the signal from the second tuner. One of the two tuners, tuner one in the embodiment described above may have modifications which can be inserted and removed from the signal path via switches to be capable of receiving the digital or the analog signal component of the hybrid broadcast system. The digitally broadcast signal component may be comprised in the side band of the transmitted signals. In order to correctly identify and extract the digitally broadcast signal components, additional filtering components may be needed in the first tuner which can be inserted and removed depending on the reception situation.

### Brief description of the drawings

Further aspects of the invention will become apparent to those skilled in the art upon reading and understanding the following detailed description with reference to the accompanying drawings.
Figure 1 shows a block diagram of a hybrid receiver working in a first operating mode,
Figure 2 is flow chart showing the operating of the receiver in the different operating modes,
Figure 3 shows the receiver working in a second operating mode,
Figure 4 shows the receiver working in the third operating mode,
Figure 5 shows a flow chart showing another embodiment of the different operating modes,
Figure 6 shows a flow chart comprising the steps of yet another embodiment of the three operating modes, and
Figure 7 shows a flow chart of still another embodiment of the three operating modes.

### Detailed description of preferred embodiments

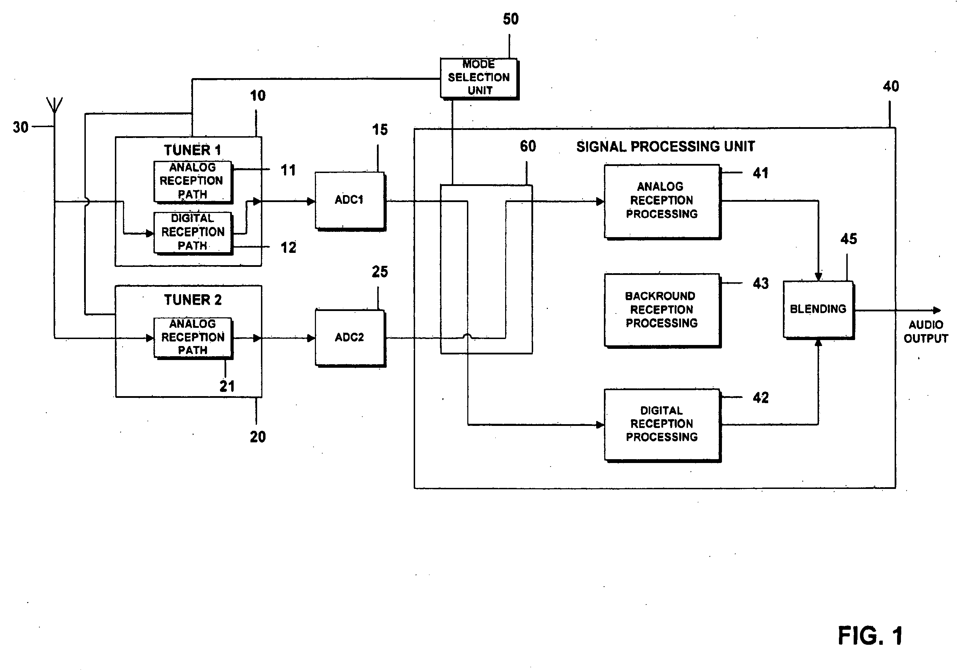

In Figure 1 a radio receiver according to the invention is shown. The radio receiver is configured for receiving a hybrid broadcast signal comprising digitally and analogously broadcast signal components. By way of example such a hybrid broadcasting system is known in the art as HD radio. The receiver comprises a first tuner 10 and a second tuner 20. These two tuners 10 and 20 receive signals from at least one antenna 30. It should be understood that more than one antenna can be provided. Especially in cases when the radio receiver of Figure 1 is incorporated into a vehicle, the receiver may also be connected to two or more antennas located at different positions within the vehicle.

The first tuner 10 comprises an analog reception path 11 and a digital reception path 12, so that the first tuner 10 is capable of receiving analog and digital signal components. In the example shown the tuner 20 comprises only one analog reception path 21. This signal's output from the first tuner 10 is fed to a first analog-to-digital-converter ADC1 15 where the signal, which is not yet demodulated and decoded, is converted into a digital signal for the signal processing unit 40. The signal from the second tuner 20 is input into a second analog-to-digital-converter ADC2 25, the output of the converter 25 also being transferred to the signal processing unit 40. The signal processing unit now comprises an analog reception processing module 41, a digital reception processing module 42 and a background reception processing 43. In the digital reception processing the digitally broadcast signal received by tuner 1 and the digital reception path is further processed (e.g. demodulated and decoded). In the analog reception processing module 41 the analogously broadcast signal received either from tuner 2 or from the analog reception path of tuner 1 is processed. In the background reception processing the received signals are not used for the audio output, but the receiver status is a search and check receiving status searching for additional information comprised in the broadcast signal and searching for other frequencies for the radio programs which can be received via the antenna 30.

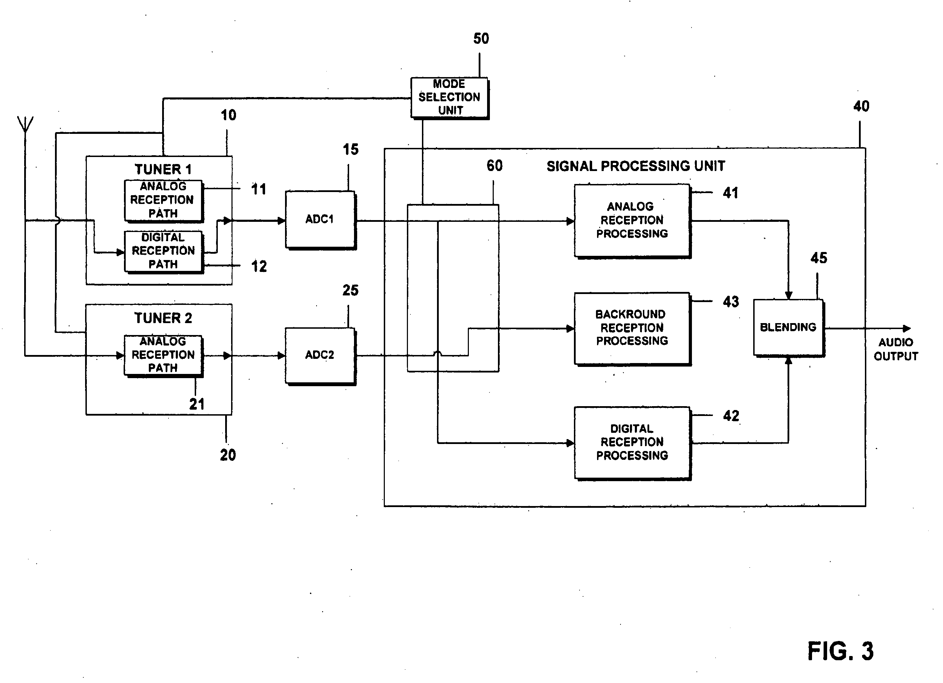

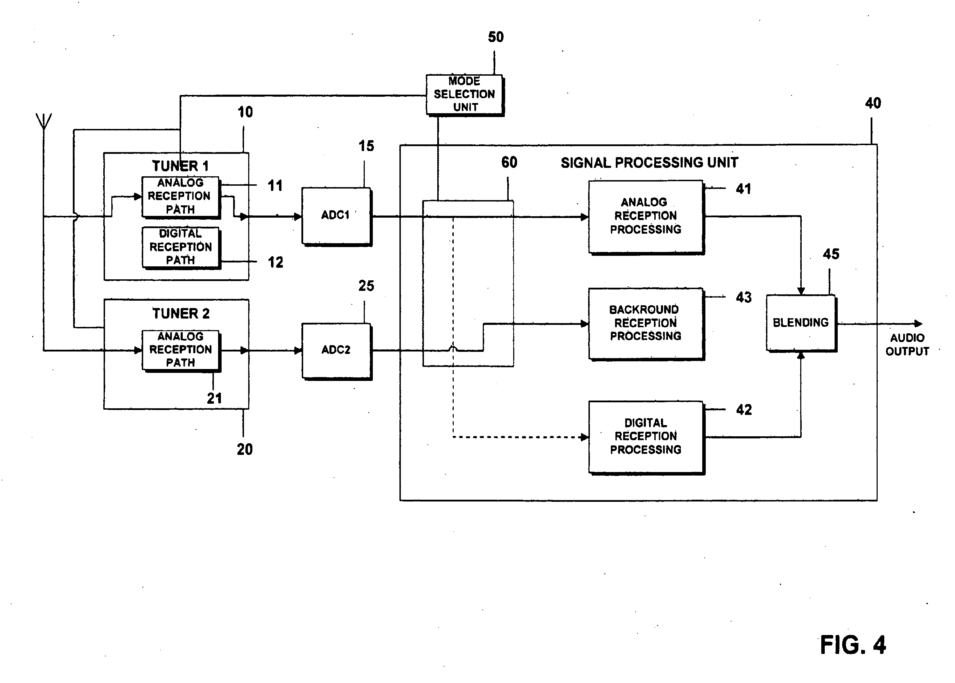

One of the processed signal, either the output signal of the analog reception processing module 41 or of the digital reception processing module 42, is selected for the audio output. The selection is done by a blending or switching module 45. In view of the two tuners and the different processing capabilities different possibilities for operating the receiver exist. In Figure 1 an operation mode selection unit 50 is symbolically shown. The operating mode selection unit controls the functioning of the two tuners and of a switch 60 coupling the output of the ADCs 15 and 25 to the different reception processing modules 41 to 43 and the selection which of the signal is used for the audio output. The radio receiver can work in at least three different operating modes, a first operating mode in which both tuners are tuned to the same frequency, the first tuner receiving, if present, the digitally broadcast signal, the second tuner receiving the analogously broadcast signal. This first operating mode is shown in Figure 1. Additionally, a second operating mode is possible in which the first tuner receives the digital signal component, this signal being used for the audio output, the second tuner being used for the background processing. This operating mode will be explained lateron in connection with Figure 3. Last but not least, a third operating mode is possible in which no digital signal component is available, so that both tuners work on the analog reception path, one being the operating tuner, the other being the background processing tuner as shown in connection with Figure 4.

In Figure 1 the first operating mode is shown. In this first operating mode, which may be used when the receiver was tuned to a new frequency, both tuners are tuned to the same frequency, the first tuner 10 being configured for receiving the digitally broadcast signal. The output of tuner 1 is then fed to the ADC 15 and is, within the signal processing unit, transmitted to the digital reception processing. The output signal of the second tuner 20 is fed to the signal processing unit 40 via the second converter 25 for demodulating and decoding the analog broadcast signal. Normally the processing of the digitally broadcast signal takes longer so that at first the audio signal of the analog reception path will be output. The analog signal has to be received via the second tuner because the first tuner is modified for reception of the digital signal component in this operating mode so the analog reception performance could be degraded if the first tuner was used. As soon as the digital signal is acquired and an audio output from the digital reception processing module 42 becomes available, the audio output of the receiver will be blended to the digital audio signal. When a digital audio signal has been received and decoded the receiver may change the operating mode to the second operating mode which is shown in Figure 3. In Figure 3 the radio receiver is shown in an operating state where the digitally broadcast signal is used for the audio output. In Figure 3 the components having the same reference numerals as in Figure 1 correspond to the one shown in Figure 1 and are not explained in detail any more. The embodiment shown in Figure 3 differs from the embodiment shown in Figure 1 by the fact, that in the switch 60 the signal received from the first tuner is fed to the analog reception processing module 41 and the digital reception processing 42. Tuner 2 is now used for the background reception as can be seen from the connection of the converter 25 to the background reception processing modules 43. The output signal of the first tuner 10 is additionally fed to the analog reception processing module via the first converter 15 for demodulating and decoding of the analogously broadcast signal. If the reception quality of the digital signal component gets worse and audio output from the digital reception path is no longer available the receiver will blend back to the audio output of the analogously broadcast signal received via tuner 10. A control unit (not shown) has to make sure that the loss of digital audio output is detected fast enough to avoid noticeable degradation of the reception quality because the analog broadcast signal is received via the first tuner at this moment.

When no digital signal component can be received, the receiver can change to a third operating mode shown in Figure 4. Figure 4 corresponds to Figures 1 and 3, however, in the first tuner the analog reception path is used, the output of the first tuner being used for the audio output, the second tuner being used for the background reception processing. In this third operating mode the receiver works as a normal dual tuner receiver, the first tuner being configured for optimum reception quality while the second tuner is used for background reception. As shown by the dashed arrow the signal of the first tuner can also be transmitted by the digital reception processing.

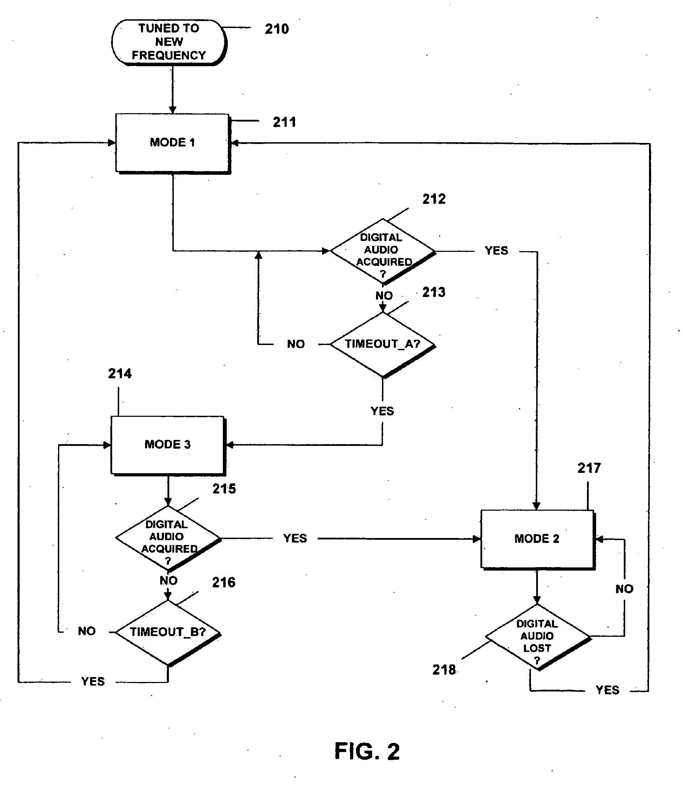

In Figure 2 a flow chart is shown showing in which situation the different operating modes are used. By way of example, when the receiver is tuned to a new frequency in step 210, the receiver is configured to work in the first operating mode as shown in step 211. In this first operating mode it is checked whether a digital signal component can be received. This examination is carried out in step 212. When no digital signal component can be received for a predetermined amount of time, e.g. timeout A (step 213) the receiver changes the operating mode to the third operating mode as shown in step 214. In this third operating mode the receiver works as indicated in Figure 4. In a moving vehicle the availability of digitally broadcast signal components varies so that it is asked in step 215 whether a digitally broadcast signal becomes available. If no digital signal component can be acquired for a timeout B (step 216) the system returns to the first operating mode indicated in Figure 1.

If it is determined in step 212 that a digital signal could be acquired the system changes to operating mode two as shown in step 217. When working in the second operating mode the digital reception path is used as shown in Figure 3. In step 218 it is asked whether a digitally broadcast signal can still be received. If this is not the case meaning that the digital component is lost, the system returns to operating mode one shown in step 211. If the digital signal was not lost, the system stays in the second operating mode. The control or operating mode selection unit has to make sure that the loss of digital audio output is detected fast enough to avoid noticeable degradation of the analog reception quality because the analog broadcast signal is received via the first tuner at this moment, the control unit then configures the receiver in the first operating mode again so that the analog broadcast signal is received via the second tuner again with optimized performance. In this case background reception is interrupted again. If the digital audio output does not become available again, the control unit changes the receiver configuration to operating mode three after a fixed amount of time (timeout A).

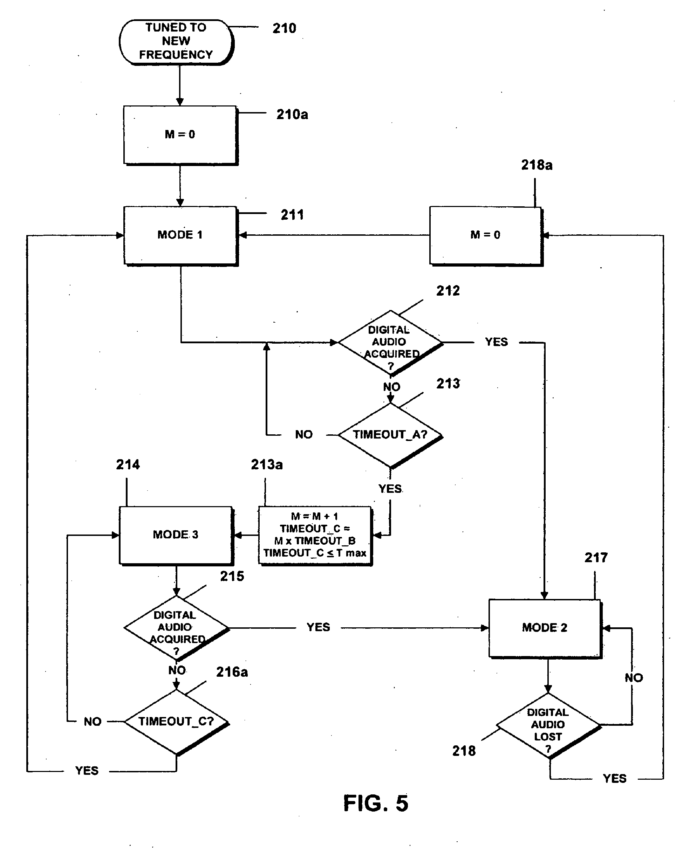

In Figure 5 another embodiment of the invention is shown. This embodiment shown in Figure 5 mainly corresponds to the embodiment shown in Figure 2. The steps having the same reference numeral as in Figure 2 function as described in connection with Figure 2 and are not explained in detail any more. The embodiment shown in Figure 5 can be used when the time for collecting background data in the third operating mode should be increased. If there is no digital signal component available or when the reception quality of the digital broadcast signal is not good enough for the audio output the rapid switching from mode three to mode one and back to mode three should be avoided, as in every switching from mode three to mode one the background reception is interrupted. When the receiver was tuned to a new frequency, a parameter M is set to zero as shown in step 210a. The parameter M indicates the number of unsuccessful attempts for receiving a digital audio component when working in the third operating mode and when changing to the first operating mode in order to look for digital signal components. In step 212 it is again asked whether digital components can be received. If this is not the case for a predetermined amount of time (timeout A) the value of M is increased and a new timeout C can be calculated in step 213a, the timeout C being calculated by using the timeout B of Figure 2 and by multiplying it with the factor M. In step 216a this timeout C is then used for changing the operating mode to the first operating mode when no digital signal component can be acquired. Supposed that in step 212 for the first time no digital audio could be detected so that in this first step the timeout B corresponds to timeout C. When the system after having worked in the third mode returns to the first mode and no digital audio is detected in step 212 again M is incremented resulting in a larger value of timeout C. This means that in step 216a the system waits longer before it returns to the first operating mode checking the availability of digitally received data. The value of timeout C can be increased until a maximum timeout Tₘₐₓ is attained. As can be seen from the embodiment shown in Figure 5 the time the receiver stays in the third operating mode supporting the background reception is increased in accordance with the unsuccessful attempts to decode an audio output of the digitally broadcast signal while being configured in the first operating mode. As soon as the receiver has demodulated and decoded the audio signal of the digital broadcast signal once the timeout is reset to its initial value by setting M to zero as indicated in step 218a.

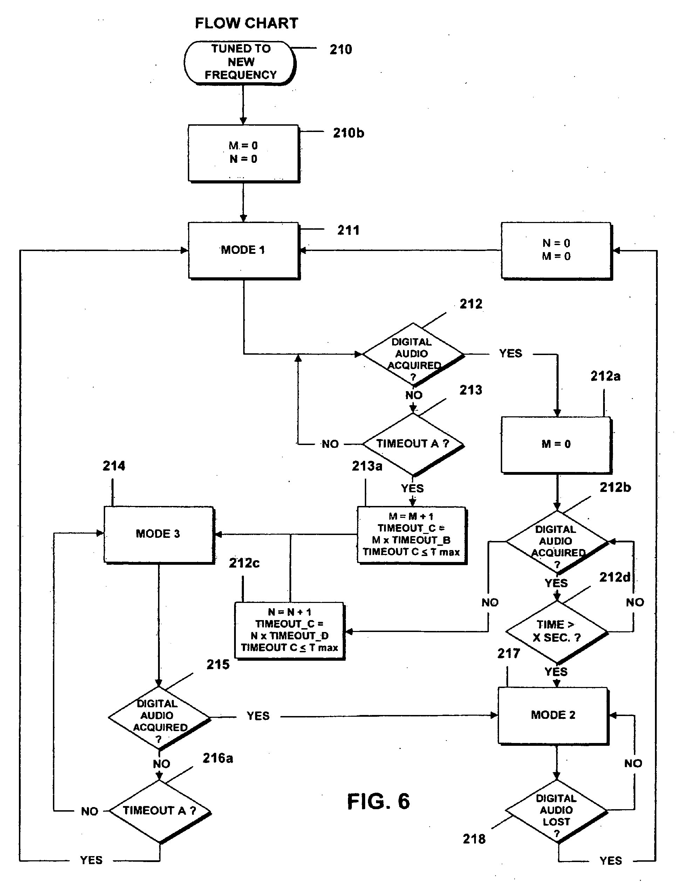

In Figure 6 another embodiment is shown which can be used in the following situations. In reception situations where the reception quality of the digital broadcast signal does not allow continuous demodulation and decoding of the corresponding audio signal leading to a frequent blending between the audio output of the digital and the analog reception path, it may be desirable to force the receiver to output the audio signal of the analog reception path for longer periods of time. To achieve this, in a further embodiment of the invention the control unit increases the time the receiver is configured in the third operating mode every time the receiver blends back from the digital audio output to the analog audio output within a predetermined amount of time X. To this end in step 210b parameters M and N are set to zero. If in step 212 a digital signal component was detected M is set to zero in step 212a. In step 212b it is again asked whether a digital audio component can be received. If this is not the case the system continues in step 212c where the parameter is N is incremented leading to an increased timeout C which is used in step 216a as described in connection with Figure 5. If in step 212b digital audio components were detected it is asked in step 212d whether the digital component was received for a time larger X seconds. If this is not the case, the system returns to step 212b. In the affirmative the system changes its operating mode to the second operating mode as indicated in step 217. The embodiment described in connection with Figure 6 helps to furthermore improve the performance of the background reception and will lead to a smoother sound impression, as too many switching operations between the different operating modes are avoided.

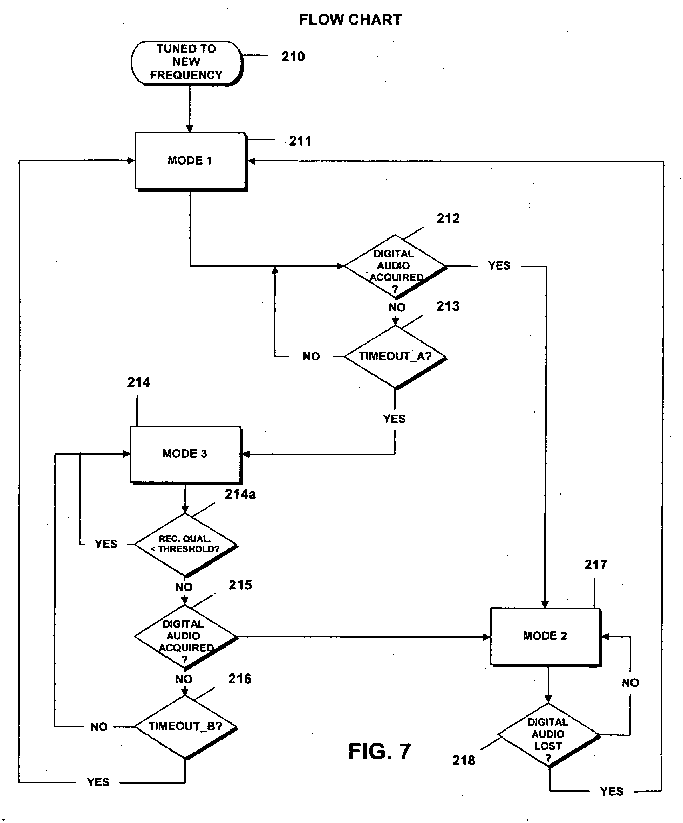

In connection with Figure 7 a further embodiment of the invention is described which is complemented to the embodiment shown in Figure 2 by additionally checking the reception quality of the desired program station while the receiver is configured in the third operating mode. The embodiment shown in Figure 7 differs from the embodiment shown in Figures 2, 5 and 6 by the fact, that after step 214 it is asked in step 214a whether the receiving quality is lower than a predetermined threshold. If the received signal quality is low, the system stays in the third operating mode, as in this case it does not make sense to look for digital audio components as the signal quality is not sufficient to properly demodulate the digitally broadcast signals.

In another embodiment not shown it is possible to change the receiver in such a way by providing an additional signal processing path or signal processing unit to allow background reception of the digitally broadcast signals as well. It should be understood that all the different embodiments described above can be combined with each other.

Summarizing this invention provides a possibility to receive a hybrid broadcast signal having an optimized background reception with a minimum amount of hardware or hardware change compared to a known receiving system having two analog receivers.

## Claims

1. Method for controlling a radio receiver comprising two tuners (10, 20), the radio receiver receiving a hybrid signal containing digitally and analogously broadcast signal components, the method comprising the following steps:
- receiving the hybrid signal and controlling the two tuners (10, 20) in such a way that a selection of the operating modes of the receiver is made between at least the following operating modes:
- a first operating mode in which both tuners (10, 20) are tuned to the same broadcast hybrid signal, one of the tuners (10) being configured for receiving the digitally broadcast signal, the other tuner (20) receiving the analogously broadcast signal,
- a second operating mode in which one of the tuners receiving the digitally broadcast signal is the operating tuner, whereas the other tuner is working as search and check tuner,
- a third operating mode in which one of the tuners receiving the analogously broadcast signal is the operating tuner, whereas the other tuner is working as a search and check tuner.

2. Method for controlling a radio receiver according to claim 1, wherein the first operating mode is selected when the receiver was tuned to a new frequency in order to check whether a digitally broadcast signal component can be received.

3. Method for controlling a radio receiver according to claim 1 or 2, **characterized by** further comprising the step of detecting whether digitally broadcast signal components can be received, and in the affirmative; selecting the second operating mode, whereas the third operating mode is selected when no digitally broadcast signal component can be received.

4. Method for controlling a radio receiver according to any of the preceding claims, wherein, when the receiver works in the third operating mode it is further more checked whether digitally broadcast signals can be received, and in the affirmative, the operating mode is changed from the third operating mode to the second operating mode.

5. Method for controlling a radio receiver according to any of the preceding claims, wherein when working in the third operating mode, after a predetermined timeout B the receives changes to the first operating mode checking whether a digitally broadcast signal has become available.

6. Method for controlling a radio receiver according to any of the preceding claims, wherein in the first operating mode the analogously broadcast signal is demodulated and decoded and the digitally broadcast signal is demodulated and decoded, the receiver changing to the digitally broadcast signal for an audio output as soon as the demodulating and decoding is finished and the digitally broadcast signal is ready to be output.

7. Method for controlling a radio receiver according to any of claims 5 or 6, wherein, when the receiver is working in the third operating mode the receiver changes to the first operating mode checking whether a digitally broadcast signal has become available, after a predetermined timeout C greater than timeout B.

8. Method for controlling a radio receiver according to claim 7, wherein the timeout C is increased with the number of unsuccessful attempts to detect digitally broadcast signals.

9. Method for controlling a radio receiver according to any of the preceding claims, wherein, when a digitally broadcast signal is detected it is asked whether the detected digitally broadcast signal can be detected for a predetermined period of time X, wherein in the affirmative the operating mode of the receiver is changed to the second operating mode, whereas when the digitally broadcast signal can not be detected for a predetermined period of time X, the operating mode of the receiver is the third operating mode.

10. Method for controlling a radio receiver according to claim 9, wherein the receiver is working in the third operating mode, the timeout C is increased with the number of unsuccessful attempts to detect a digitally broadcast signal longer than the predetermined period of time X.

11. Method for controlling a radio receiver according to any of the preceding claims, wherein, when the receiver is working in the third operating mode , the quality of the received signal is checked, and if the the quality is below a predetermined threshold value, the receiver stays in the third operating mode.

12. Method for controlling a radio receiver according to any of the preceding claims, wherein when the receiver works in the second operating mode, and when a loss of the digitally broadcast signal is detected, an audio output of the analogously broadcast signal form the tuner which was working as a search and check tuner before, is used.

13. Method for controlling a radio receiver according to claim 12, wherein, when the digitally broadcast signal does not become available again, the operation of the receiver is changed to the third operating mode after a predetermined amount of time.

14. Method for controlling a radio receiver according to any of claims 8 to 13, wherein the timeout C is reset to its starting value when a digitally broadcast signal has once been demodulated and decoded.

15. Method for controlling a radio receiver according to any of claims 8 to 14, wherein the period of time X is reset to its initial value, when the receiver has output the audio signal of the digitally broadcast signal longer than the predetermined period of time X.

16. Method for controlling a radio receiver according to any of the preceding claims, wherein, in the third operating mode, for the signal of the tuner working as search and check tuner a digitally broadcast signal processing is carried out in order to collect information from other digitally broadcast signals.

17. Method for controlling a radio receiver according to any of the preceding claims, wherein the digitally and analogously broadcast signal components are transmitted at the same frequency.

18. Radio receiver configured for receiving a hybrid signal containing digitally and analogously broadcast signal components, comprising
- a first tuner (10) adapted to receive the digitally and the analogously broadcast signals,
- a second tuner (20) adapted to receive the analogously broadcast signal,
- at least one antenna (30) receiving the hybrid signal,
- at least one signal processing unit (40) demodulating and decoding the analogously and digitally broadcast signals,
- an operating mode selection unit (50) controlling the two tuners in such a way that a selection of the operating modes of the receiver is made between at least the following operating modes:
- a first operating mode in which both tuners (10, 20) are tuned to the same broadcast hybrid signal, one of the tuners (10) being configured for receiving the digitally broadcast signal, the other tuner (20) receiving the analogously broadcast signal,
- a second operating mode in which one of the tuners (10) receiving the digitally broadcast signal is the operating tuner, whereas the other tuner (20) is working as search and check tuner,
- a third operating mode in which one of the tuners (10) receiving the analogously broadcast signal is the operating tuner, whereas the other tuner (20) is working as a search and check tuner.

19. Radio receiver according to claim 18, **characterized by** further comprising a first analog-to-digital converter (15) receiving the signals from the first tuner (10), and a second analog-to-digital converter (25) receiving the signals from the second tuner.

20. Radio receiver according to claim 18 or 19, wherein the signal processing unit comprises an analog reception processing module (41), a digital reception processing module (42) and a background reception processing module (43).

21. Radio receiver according to any of claims 18 to 20, **characterized by** further comprising switching or blending module 45 selecting either the signal processed by the analog reception processing module or the digital reception processing module for the audio output.

22. Radio receiver according to any of claims 18 to 21, wherein the radio receiver is working according to a method as mentioned in any of claims 1 to 16.

## Patentansprüche

1. Verfahren zum Steuern eines Funkempfängers, der zwei Abstimmer (10, 20) umfasst, wobei der Funkempfänger ein Hybridsignal empfängt, das digital und analog übertragene Signalkomponenten enthält, wobei das Verfahren die folgenden Schritte umfasst:
- Empfangen des Hybridsignals und Steuern der zwei Abstimmer (10, 20) derart, dass eine Auswahl der Betriebsmodi des Empfängers zwischen wenigstens den folgenden Betriebsmodi durchgeführt wird:
- einem ersten Betriebsmodus, wobei beide Abstimmer (10, 20) auf dasselbe übertragene Hybridsignal abgestimmt sind, wobei einer der Abstimmer (10) dazu konfiguriert ist, das digital übertragene Signal zu empfangen, während der andere Abstimmer (20) das analog übertragene Signal empfängt,
- einem zweiten Betriebsmodus, wobei einer der Abstimmer, der das digital übertragene Signal empfängt, der Betriebsabstimmer ist, während der andere Abstimmer als ein Such- und Prüfabstimmer arbeitet,
- einem dritten Betriebsmodus, wobei einer der Abstimmer, der das analog übertragene Signal empfängt, der Betriebsabstimmer ist, während der andere Abstimmer als ein Such- und Prüfabstimmer arbeitet.

2. Verfahren zum Steuern eines Funkempfängers nach Anspruch 1, wobei der erste Betriebsmodus ausgewählt wird, wenn der Empfänger auf eine neue Frequenz abstimmt wurde, um zu prüfen, ob eine digital übertragene Signalkomponente empfangen werden kann.

3. Verfahren zum Steuern eines Funkempfängers nach Anspruch 1 oder 2, **dadurch gekennzeichnet, dass** es ferner folgenden Schritt umfasst: Erkennen, ob digital übertragene Signalkomponenten empfangen werden können, und falls ja, Auswählen des zweiten Betriebsmodus, während der dritte Betriebsmodus ausgewählt wird, wenn keine digital übertragene Signalkomponente empfangen werden kann.

4. Verfahren zum Steuern eines Funkempfängers nach einem der vorangehenden Ansprüche, wobei dann, wenn der Empfänger im dritten Betriebsmodus arbeitet, darüber hinaus geprüft wird, ob digital übertragene Signale empfangen werden können, und falls ja, der Betriebsmodus vom dritten Betriebsmodus in den zweiten Betriebsmodus umgeschaltet wird.

5. Verfahren zum Steuern eines Funkempfängers nach einem der vorangehenden Ansprüche, wobei beim Betrieb im dritten Betriebsmodus nach einer vorgegebenen Zeitüberschreitung B der Empfänger in den ersten Betriebsmodus umschaltet und prüft, ob ein digital übertragenes Signal verfügbar geworden ist.

6. Verfahren zum Steuern eines Funkempfängers nach einem der vorangehenden Ansprüche, wobei das analog übertragene Signal im ersten Betriebsmodus demoduliert und decodiert wird und das digital übertragene Signal demoduliert und decodiert wird, wobei der Empfänger zum digital übertragenen Signal als Audioausgang umschaltet, sobald das Demodulieren und Decodieren abgeschlossen ist und das digital übertragene Signal zur Ausgabe bereit ist.

7. Verfahren zum Steuern eines Funkempfängers nach einem der Ansprüche 5 oder 6, wobei dann, wenn der Empfänger im dritten Betriebsmodus arbeitet, der Empfänger nach einer vorgegebenen Zeitüberschreitung C, die größer als die Zeitüberschreitung B ist, in den ersten Betriebsmodus umschaltet und prüft, ob ein digital übertragenes Signal verfügbar geworden ist.

8. Verfahren zum Steuern eines Funkempfängers nach Anspruch 7, wobei die Zeitüberschreitung C mit der Anzahl erfolgloser Versuche zum Erkennen digital übertragener Signale erhöht wird.

9. Verfahren zum Steuern eines Funkempfängers nach einem der vorangehenden Ansprüche, wobei dann, wenn ein digital übertragenes Signal erkannt wird, gefragt wird, ob das erkannte digital übertragene Signal für einen vorgegebenen Zeitraum X erkannt werden kann, und falls ja, der Betriebsmodus des Empfängers in den zweiten Betriebsmodus umgeschaltet wird, während der Betriebsmodus des Empfängers für den Fall, dass das digital übertragene Signal nicht für einen vorgegebenen Zeitraum X erkannt werden kann, der dritte Betriebsmodus ist.

10. Verfahren zum Steuern eines Funkempfängers nach Anspruch 9, wobei dann, wenn der Empfänger im dritten Betriebsmodus arbeitet, die Zeitüberschreitung C mit der Anzahl erfolgloser Versuche zum Erkennen eines digital übertragenen Signals erhöht wird, die länger als der vorgegebene Zeitraum X sind.

11. Verfahren zum Steuern eines Funkempfängers nach einem der vorangehenden Ansprüche, wobei dann, wenn der Empfänger im dritten Betriebsmodus arbeitet, die Qualität des empfangenen Signals geprüft wird, und wenn die Qualität unter einem vorgegebenen Schwellenwert ist, der Empfänger im dritten Betriebsmodus bleibt.

12. Verfahren zum Steuern eines Funkempfängers nach einem der vorangehenden Ansprüche, wobei dann, wenn der Empfänger im zweiten Betriebsmodus arbeitet und wenn ein Verlust des digital übertragenen Signals erkannt wird, ein Audioausgang des analog übertragenen Signals von dem Abstimmer, der zuvor als ein Such- und Prüfabstimmer arbeitete, benutzt wird.

13. Verfahren zum Steuern eines Funkempfängers nach Anspruch 12, wobei dann, wenn das digital übertragene Signal nicht wieder verfügbar wird, der Betrieb des Empfängers nach einem vorgegebenen Zeitraum in den dritten Betriebsmodus umgeschaltet wird.

14. Verfahren zum Steuern eines Funkempfängers nach einem der Ansprüche 8 bis 13, wobei die Zeitüberschreitung C auf ihren Ausgangswert zurückgesetzt wird, wenn ein digital übertragenes Signal einmal demoduliert und decodiert wurde.

15. Verfahren zum Steuern eines Funkempfängers nach einem der Ansprüche 8 bis 14, wobei der Zeitraum X auf seinen Anfangswert zurückgesetzt wird, wenn der Empfänger das Audiosignal des digital übertragenen Signals länger als den vorgegebenen Zeitraum X ausgegeben hat.

16. Verfahren zum Steuern eines Funkempfängers nach einem der vorangehenden Ansprüche, wobei im dritten Betriebsmodus für das Signal des Abstimmers, der als Such- und Prüfabstimmer arbeitet, eine Verarbeitung für digitale übertragene Signale ausgeführt wird, um Informationen von anderen digital übertragenen Signalen zu erfassen.

17. Verfahren zum Steuern eines Funkempfängers nach einem der vorangehenden Ansprüche, wobei die digital und analog übertragenen Signalkomponenten auf derselben Frequenz gesendet werden.

18. Funkempfänger, der zum Empfangen eines Hybridsignals konfiguriert ist, das digital und analog übertragene Signalkomponenten enthält, umfassend
- einen ersten Abstimmer (10), der zum Empfangen des digital und des analog übertragenen Signals angepasst ist,
- einen zweiten Abstimmer (20), der zum Empfangen des analog übertragenen Signals angepasst ist,
- wenigstens eine Antenne (30), die das Hybridsignal empfängt,
- wenigstens eine Signalverarbeitungseinheit (40), die die analog und digital übertragenen Signale demoduliert und decodiert,
- eine Betriebsmodusauswahleinheit (50), die die zwei Abstimmer derart steuert, dass eine Auswahl der Betriebsmodi des Empfängers zwischen wenigstens den folgenden Betriebsmodi durchgeführt wird:
- einem ersten Betriebsmodus, wobei beide Abstimmer (10, 20) auf dasselbe übertragene Hybridsignal abgestimmt sind, wobei einer der Abstimmer (10) dazu konfiguriert ist, das digital übertragene Signal zu empfangen, während der andere Abstimmer (20) das analog übertragene Signal empfängt,
- einem zweiten Betriebsmodus, wobei einer der Abstimmer (10), der das digital übertragene Signal empfängt, der Betriebsabstimmer ist, während der andere Abstimmer (20) als ein Such- und Prüfabstimmer arbeitet,
- einem dritten Betriebsmodus, wobei einer der Abstimmer (10), der das analog übertragene Signal empfängt, der Betriebsabstimmer ist, während der andere Abstimmer (20) als ein Such- und Prüfabstimmer arbeitet.

19. Funkempfänger nach Anspruch 18, **dadurch gekennzeichnet, dass** er ferner einen ersten Analog-Digital-Wandler (15), der die Signale vom ersten Abstimmer (10) empfängt, und einen zweiten Analog-Digital-Wandler (25) umfasst, der die Signale vom zweiten Abstimmer empfängt.

20. Funkempfänger nach Anspruch 18 oder 19, wobei die Signalverarbeitungseinheit ein Analogempfangsverarbeitungsmodul (41), ein Digitalempfangsverarbeitungsmodul (42) und ein Hintergrundempfangsverarbeitungsmodul (43) umfasst.

21. Funkempfänger nach einem der Ansprüche 18 bis 20, **dadurch gekennzeichnet, dass** er ferner ein Schalt- oder Mischmodul (45) umfasst, das entweder das von dem Analogempfangsverarbeitungsmodul verarbeitete oder das vom Digitalempfangsverarbeitungsmodul verarbeitete Signal als Audioausgang auswählt.

22. Funkempfänger nach einem der Ansprüche 18 bis 21, wobei der Funkempfänger gemäß einem Verfahren nach einem der Ansprüche 1 bis 16 arbeitet.

## Revendications

1. Procédé de commande d'un récepteur radio comprenant deux syntoniseurs (10, 20), le récepteur radio recevant un signal hybride contenant des composantes de signaux émises par voie numérique et analogique, ce procédé comprenant les étapes suivantes :
- réception du signal hybride et contrôle des deux syntoniseurs (10, 20) de manière qu'une sélection des modes d'opération du récepteur se fasse entre au moins les modes suivants d'opération :
- un premier mode d'opération dans lequel les deux syntoniseurs (10, 20) sont syntonisés sur le même signal hybride émis, un des syntoniseurs (10) étant configuré pour recevoir le signal émis numériquement, l'autre syntoniseur (20) recevant le signal émis par voie analogique,
- un deuxième mode d'opération dans lequel l'un des syntoniseurs recevant le signal émis numériquement est le syntoniseur en cours d'opération, tandis que l'autre syntoniseur fonctionne en tant que syntoniseur de recherche et de contrôle,
- un troisième mode d'opération dans lequel l'un des syntoniseurs recevant le signal émis par voie analogique est le syntoniseur en cours d'opération, tandis que l'autre syntoniseur fonctionne en tant que syntoniseur de recherche et de contrôle.

2. Procédé de commande d'un récepteur radio selon la revendication 1, dans lequel le premier mode d'opération est choisi lorsque le récepteur a été syntonisé à une nouvelle fréquence, afin de contrôler si une composante de signaux émis numériquement peut être reçue.

3. Procédé de commande d'un récepteur radio selon la revendication 1 ou 2, **caractérisé en ce qu'**il comprend en outre l'étape de détection si les composantes des signaux émis numériquement peuvent être reçues, et dans l'affirmative, le choix du deuxième mode d'opération, tandis que le troisième mode d'opération est choisi quand aucune composante du signal émis numériquement ne peut être reçue.

4. Procédé de commande d'un récepteur radio selon l'une quelconque des revendications précédentes, dans lequel, lorsque le récepteur fonctionne dans le troisième mode d'opération, on contrôle encore si des signaux émis numériquement peuvent être reçus et dans l'affirmative, le mode d'opération est changé du troisième mode d'opération au deuxième mode d'opération.

5. Procédé de commande d'un récepteur radio selon l'une quelconque des revendications précédentes, dans lequel, lorsque le récepteur fonctionne dans le troisième mode d'opération, après un temps mort prédéterminé B, il passe au premier mode d'opération en contrôlant si un signal émis numériquement est devenu disponible.

6. Procédé de commande d'un récepteur radio selon l'une quelconque des revendications précédentes, dans lequel, dans le premier mode d'opération, le signal émis par voie analogique est démodulé et décodé et où le signal émis numériquement est démodulé et décodé, le récepteur passant au signal émis numériquement pour une sortie audio dès que la démodulation et le décodage ont pris fin et que le signal émis numériquement est prêt à être émis.

7. Procédé de commande d'un récepteur radio selon l'une quelconque des revendications 5 ou 6, dans lequel, lorsque le récepteur fonctionne dans le troisième mode d'opération, il passe au premier mode d'opération en contrôlant si un signal émis numériquement est devenu disponible, au bout d'un temps mort prédéterminé C supérieur au temps mort B.

8. Procédé de commande d'un récepteur radio selon la revendication 7, dans lequel le temps mort C augmente avec le nombre de tentatives infructueuses visant à détecter des signaux émis numériquement.

9. Procédé de commande d'un récepteur radio selon l'une quelconque des revendications précédentes, dans lequel, lorsqu'un signal émis numériquement est détecté, on demande si le signal émis numériquement peut être détecté pendant une durée prédéterminée X, dans lequel dans l'affirmative, le mode d'opération du récepteur passe au deuxième mode d'opération, alors que quand le signal émis numériquement n'est pas détecté pendant une durée prédéterminée X, le mode d'opération du récepteur est le troisième mode d'opération.

10. Procédé de commande d'un récepteur radio selon la revendication 9, dans lequel quand le récepteur fonctionne dans troisième mode d'opération, le temps mort C augmente avec le nombre de tentatives infructueuses de détection d'un signal émis numériquement qui dépasse la durée prédéterminée X.

11. Procédé de commande d'un récepteur radio selon l'une quelconque des revendications précédentes, dans lequel, lorsque le récepteur fonctionne dans le troisième mode d'opération, la qualité du signal reçu est contrôlée, et si la qualité est inférieure à une valeur seuil prédéterminée, le récepteur reste dans le troisième mode d'opération.

12. Procédé de commande d'un récepteur radio selon l'une quelconque des revendications précédentes, dans lequel, lorsque le récepteur fonctionne dans le deuxième mode d'opération et lorsqu'une perte du signal émis numériquement est détectée, on utilise une sortie audio du signal émis par voie analogique depuis le syntoniseur qui fonctionnait en tant que syntoniseur de recherche et de contrôle auparavant.

13. Procédé de commande d'un récepteur radio selon la revendication 12, dans lequel, lorsque le signal émis numériquement ne redevient pas disponible, l'opération du récepteur passe au troisième mode d'opération au bout d'un laps de temps prédéterminé.

14. Procédé de commande d'un récepteur radio selon l'une quelconque des revendications 8 à 13, dans lequel le temps mort C est remis à zéro à sa valeur de départ lorsqu'un signal émis numériquement a été démodulé et décodé une fois.

15. Procédé de commande d'un récepteur radio selon l'une quelconque des revendications 8 à 14, dans lequel la durée X est remise à sa valeur initiale lorsque le récepteur a émis le signal audio du signal émis numériquement au-delà de la durée prédéterminée X.

16. Procédé de commande d'un récepteur radio selon l'une quelconque des revendications précédentes, dans lequel, dans le troisième mode d'opération, pour le signal du syntoniseur fonctionnant en tant que syntoniseur de recherche et de contrôle, un traitement des signaux émis numériquement a lieu afin de recueillir des informations à partir d'autres signaux émis numériquement.

17. Procédé de commande d'un récepteur radio selon l'une quelconque des revendications précédentes, dans lequel les composantes des signaux émis par voie numérique et analogique sont transmises à la même fréquence.

18. Récepteur radio configuré pour recevoir un signal hybride contenant des composantes de signaux émis par voie numérique et analogique, comprenant
- un premier syntoniseur (10) conçu pour recevoir les signaux émis par voie numérique et analogique,
- un deuxième syntoniseur (20) conçu pour recevoir le signal émis par voie analogique,
- au moins une antenne (30) recevant le signal hybride,
- au moins une unité de traitement des signaux (40) démodulant et décodant les signaux émis par voie analogique et numérique,
- une unité (50) de sélection du mode d'opération commandant les deux syntoniseurs de sorte qu'un choix des modes d'opération du récepteur se fasse entre au moins les modes suivants d'opération :
- un premier mode d'opération dans lequel les deux syntoniseurs (10, 20) sont syntonisés sur le même signal hybride d'émission, l'un des syntoniseurs (10) étant configuré pour recevoir le signal émis numériquement, l'autre syntoniseur (20) recevant le signal émis par voie analogique,
- un deuxième mode d'opération dans lequel l'un des syntoniseurs (10) recevant le signal émis numériquement est le syntoniseur d'opération, alors que l'autre syntoniseur (20) fonctionne en tant que syntoniseur de recherche et de contrôle,
- un troisième mode d'opération dans lequel l'un des syntoniseurs (10) recevant le signal émis par voie analogique est le syntoniseur d'opération, alors que l'autre syntoniseur (20) fonctionne en tant que syntoniseur de recherche et de contrôle.

19. Récepteur radio selon la revendication 18, **caractérisé en ce qu'**il comprend en outre un premier convertisseur analogique / numérique (15) recevant les signaux à partir du premier syntoniseur (10) et un deuxième convertisseur analogique / numérique (25) recevant les signaux à partir du deuxième syntoniseur.

20. Récepteur radio selon la revendication 18 ou 19, dans lequel l'unité de traitement des signaux comprend un module (41) de traitement de la réception analogique, un module (42) de traitement de la réception numérique et un module (43) de traitement de la réception d'arrière-plan.

21. Récepteur radio selon l'une quelconque des revendication 18 à 20, **caractérisé par** le fait de comprendre en outre la commutation ou le mélange du module 45 par choix soit du signal traité par le module de traitement de la réception analogique, soit du module de traitement de la réception numérique pour la sortie audio.

22. Récepteur radio selon l'une quelconque des revendication 18 à 21, dans lequel le récepteur radio fonctionne selon un procédé mentionné dans l'une quelconque des revendications 1 à 16.
